# EUROPEAN PATENT SPECIFICATION

(11) **EP 1 577 114 B1**
(45) Date of publication and mention of the grant of the patent: **20.05.2009**
(21) Application number: 02711880.1
(22) Date of filing: 08.02.2002
(51) Int. Cl.: B41C 1/05, G03F 7/20

(54) **DEVICE FOR POSITIONING A CURING RADIATION SOURCE ON AN ENGRAVING CYLINDER OR AN ENGRAVING PLATE HOLDER**
VORRICHTUNG ZUR POSITIONIERUNG EINER STRAHLUNGSAUSHÄRTUNGSQUELLE AN EINEM GRAVIERZYLINDER ODER EINEM GRAVIERPLATTENHALTER
DISPOSITIF DE POSITIONNEMENT D'UNE SOURCE DE RAYONNEMENT DE DURCISSEMENT SUR UN CYLINDRE GRAVEUR OU UN PORTE-PLAQUES DE GRAVURE

(43) Date of publication of application: 21.09.2005
(73) Proprietor: NEOPACK, SL, 08007 Barcelona (ES)
(72) Inventor: AMAT TARRES, Joaquin, S-17005 Girona (ES)
(74) Representative: Gislon, Gabriele
(86) International application number: PCT/ES2002/000063
(87) International publication number: WO 2003/066340

(56) References cited:
- EP-A- 0 639 452
- EP-A- 0 828 196
- EP-A2- 0 338 378
- GB-A- 2 323 177
- US-A- 5 116 548
- US-A- 5 989 780

## Description

### Field of the invention

This invention relates to a device for positioning a radiation source such as an ultra-violet (UV), or other kind of radiation, curing lamp, to an engraving cylinder or an engraving plate holder in a machine for printing images with optical effects or other types of printing such as holographs, where a layer of resin associated with a flexible laminate substrate is relief shaped by said engraving cylinder at the same time as it is cured by the radiation from said lamp, through the substrate.

### Technical background

The technique is known of printing images with optical refraction effects, such as holograms, by moulding a layer of a liquid transparent resin onto a mould containing the information to be engraved in a superficial micro-relief structure and by curing said resin at the same time as it is moulded, that is, when it is in contact with the mould. The resin is cured by an actinic radiation lamp, such as an ultra-violet radiation, or electron radiation, lamp.

Patent GB-2027441 describes a moulding technique in a continuous process where a substrate of a flexible laminar material in the form of a web is passed over part of the circumference of a rotary engraving cylinder without any relative movement between them. The external surface of the cylinder has a relief configuration in the form of the micro-structure that is to be reproduced, like a mould. On the surface of the rotary cylinder a liquid moulding resin is applied just before it comes into contact with the laminate substrate. This way, in the area where the cylinder and the substrate come into contact, the moulding resin lies between the mould-like relief configuration on the cylinder surface and the laminate substrate. The resin is hardened in this area through curing by applying actinic radiation to the resin from the back of the substrate, that is, through the substrate. When the laminate substrate is subsequently separated from the cylinder, a layer of hardened resin is adhered to one side of the surface of said cylinder with the exposed face showing a relief reproduction of the micro-structure of the engraving cylinder mould. If the substrate is transparent or translucent an ultra-violet lamp is used for curing, but if it is optically opaque an electrons radiation lamp is used, as it can penetrate the substrate with hardly any attenuation.

Patent US-5116548 discloses a development of the technique described above which introduces an improvement that allows a large number of copies to be reproduced of one single hologram at each turn of the cylinder, and then separated individually and each stuck onto the surface of an object. The engraving and curing technique used is essentially the same, except that in this case, in one embodiment, the liquid resin is applied to the laminate substrate before it passes by the engraving cylinder. The engraving cylinder includes a support roller, around which, there is wrapped the mould proper or "master" in the shape of a fine sheet that contains the information to be engraved in the form of a micro-relief structure.

Patent US-5003915 describes a method and apparatus for improving the performance in a process for producing holograms on previously printed objects, where, in one embodiment, in a continuous process, a web of laminate substrate, such as paper, is first printed on one or both surfaces with conventional two-dimensional information and is subsequently dried, then the hologram is moulded onto discrete duly defined areas, on one surface of the printed substrate, and a refracting or reflectant metallic layer is applied to the discrete areas of the hologram, followed by a transparent protective coating on either only the metallic hologram or on the whole of the substrate surface, with it being possible to subsequently print said coating. Also here essentially the same engraving and curing technique is used, except that the information in micro-relief to be engraved is on raised discrete areas, protruding from the surface of the engraving cylinder, onto which the liquid resin is applied before these areas come into contact with the previously printed laminate substrate. As in the afore-mentioned background cases, curing is performed by applying actinic radiation to the resin through the substrate material while the resin is in contact with the mould.

Patent EP-0540455 discloses a method for preparing sheets printed with optical effects, said sheets consisting in a sheet of plastics material worked like a lens through which motifs arranged behind said sheet can be viewed, with the relevant motifs or illustrations being printed on said sheets, on at least one of their surfaces by means of any conventional system and a transparent resin being applied to the surface to be printed, that completely or partially impregnates the surface of the sheet, after which the engraving is carried out in the impregnated area, which will produce the said optical effects, with said transparent resin being polymerised by an ultra-violet radiation source, with the particular feature that the engraving on the resin-covered surface of the sheets is performed at the same time as said polymerisation.

Preparing a transparent cylinder on the surface of which a transparent laminar mould is mounted, which is necessary for applying the resin radiation technique from inside the engraving cylinder, is very expensive, and therefore it is preferable to radiate the resin from the opposite side of the substrate and, consequently, through said substrate. For this, a lamp or source of actinic radiation must be positioned aiming at the area of the engraving cylinder remaining in contact with the resin and the substrate during the continuous engraving process. The distance between the lamp and the resin layer surface to be radiated must correspond relatively accurately to the focal distance of the lamp, whereby it is essential that the lamp be positioned correctly with respect to the external surface, or mould, of the cylinder. Since the lamp is supported mechanically on the same frame or structure as the apparatus supporting the cylinder shaft, the correct position of the lamp with respect to the frame corresponds to said distance between the lamp and the cylinder surface, or focal distance, plus the cylinder radius. Therefore, although the focal distance is fixed for one and the same lamp, when different diameter engraving cylinders are used, each time the cylinder is changed, the lamp has to be re-positioned with respect to the cylinder shaft in function of the diameter thereof in order to maintain the appropriate focal distance with respect to the external surface of the cylinder, which implies having to make frequent and relatively accurate adjustments that are time consuming.

### Disclosure of the invention

The object of this invention is to provide a device that avoids the drawback described above by making it possible to position the actinic radiation lamp automatically, quickly and accurately with respect to the external surface of the engraving cylinder every time a new engraving cylinder is placed in the engraving unit, regardless of the diameter of said cylinders.

This object is achieved by fitting the shaft of each engraving cylinder with support discs, placed on the sides of the cylinder and separated therefrom, with end stops resting on and adapting to said discs, that are associated with a mobile support structure for the lamp. Said end stops have a fixed length while the diameter of the support discs depends on the diameter of the engraving cylinder, so that, for each engraving cylinder, the sum of the radius of its corresponding support discs and the length of the end stops provides an adequate and accurate distance between the lamp and the external surface of the cylinder, that corresponds to the focal distance of the lamp.

Said lamp support structure is mounted so that it can pivot with respect to a shaft. At least one fluid dynamic cylinder is connected mechanically to said structure to make it pivot on said shaft in order to bring the lamp closer or move it away from the cylinder. The axial distance between the support discs is fixed for all engraving cylinders and coincides with the axial distance between the end stops so that, when they are moved towards the cylinder, they will always meet contact surfaces on said support discs. Preferably, said contact surfaces on the support discs have a flat, relatively narrow and substantially cylindrical edge, from which there protrudes a circumferential flange with angled, i.e.: conical sides. The end stops have a relatively narrow contact surface, substantially in the shape of a concave cylindrical sector, on the contact surface of which there is formed a groove with angled, i.e.: conical sides, its depth and conicity being equivalent to the height and conicity of the support disc flanges. The curvature radius of the cylindrical shaped contact surface of the end stops is equivalent to the maximum permissible guide disc radius. Therefore, when the radius of the discs is less than the maximum permitted, the respective contact surfaces of the discs and end stops only rest on one point. Each end stop includes a pair of movable side pins, mounted in a pivoting manner and controlled independently by fluid dynamic cylinders to pivot towards the corresponding guide disc until it comes into contact with the end stop, so as to provide a stable support on at least three points; said support point between the central end stop and the disc, of which there is at least one, and at least two other support points; one between each of the side pins and the support disc. Each side pin also has a concave support surface provided with a groove having angled, i.e.: conical sides, its depth and conicity being equivalent to the height and conicity of the support disc flanges. The grooves on the side pin contact surfaces are aligned with the groove on the contact surface of the central end stop. When the end stop contact surfaces and their respective pins come into contact with the contact surfaces on the corresponding support discs, the engagement between the angled sides of the flanges and the grooves helps to centre the lamp accurately in an axial direction while contact between the flat, substantially cylindrical surfaces, ensures an accurate distance between the lamp and the external surface of the engraving cylinder in question, which corresponds to the focal distance of the lamp.

In order to replace an engraving cylinder, first the fluids dynamic cylinder associated with the lamp support structure is activated to move the lamp away from the cylinder and place it outside the interference range therewith, then the cylinder to be withdrawn is extracted and the new one is put in place following the conventional methods in the art, the new cylinder incorporating its corresponding shaft and support discs, and then said fluids dynamic cylinder is activated again so as to turn the structure and move the lamp towards the recently positioned cylinder until the end stops come into contact with the support discs, which provides the necessary distance between the lamp and the cylinder, and finally the fluids dynamic cylinders associated with the side pins are activated to close said pins until they come into contact with the support discs, which provides stable support for the lamp support structure with at least three support points at each cylinder end.

Advantageously, the support discs are mounted by means of bearings, such as ball bearings, on the engraving cylinder shaft so that said shaft turns with respect to the support discs while said discs remain stationary with respect to the corresponding end stops and pins, thus avoiding any problems arising from friction between these parts.

So, with the device of this invention the actinic radiation lamp can be positioned in an automatic, quick and accurate manner with respect to the external surface of the engraving cylinder every time a new engraving cylinder is placed in the engraving unit, regardless of the diameter thereof, by simply incorporating the support discs and end stops described above and slightly modifying the lamp support structure, which can both be carried out easily on an existing apparatus.

### Brief explanation of the drawings

In order provide a better understanding of the invention, this shall be described below with reference to a specific embodiment and the attached drawings, in which:
Fig. 1 is a diagram illustrating the operation of an apparatus for continuously forming a micro-relief that produces optical effects on a flexible laminate substrate;
Fig. 2 is a partially sectioned front view showing a curing lamp positioned by the device of this invention on an engraving cylinder in an apparatus such as that shown in Fig. 1;
Figs. 3 and 4 are side views showing respectively the curing lamp in its inactive and active positions during the operation of the device of this invention;
Fig. 5 is an enlarged, sectioned view of a detail of Fig. 1, but with the end stop and support disc separated from each other to show the profile of their contact surfaces;
Fig. 6 is a lower plan view of a end stop with its side pins, showing the contact surfaces thereof; and
Figs. 7 and 8 are side views of one of the end stops of the device of this invention with the side pins adjusted on different diameter support discs.

### Detailed description of a preferred embodiment

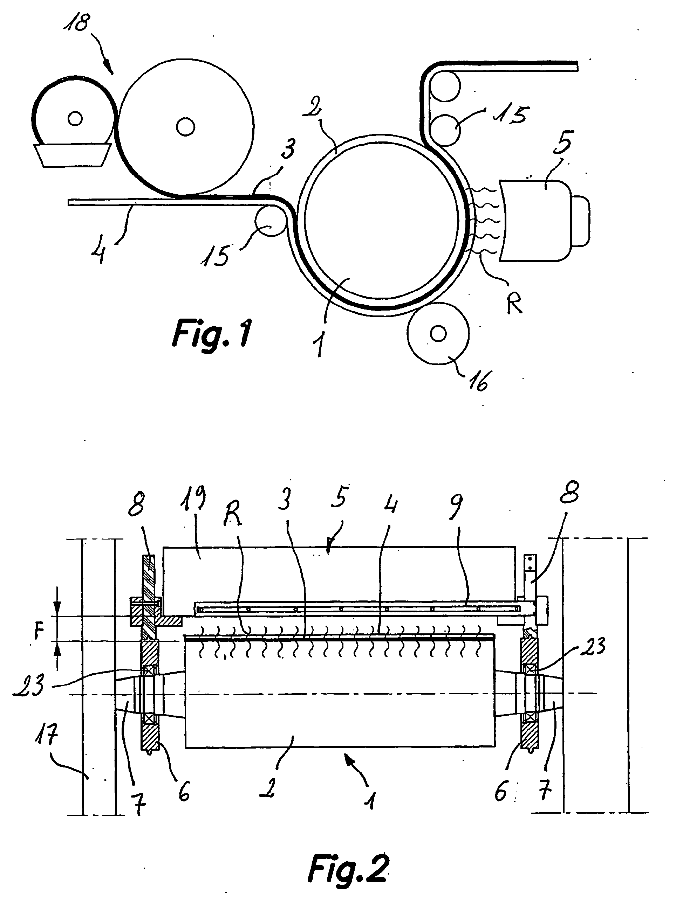

First of all, with reference to Fig. 1, this is a diagrammatic representation of a typical engraving unit in an apparatus for continuously forming a micro-relief that produces optical effects on a flexible laminate substrate, with the engraving unit comprising a motorised support where an engraving cylinder 1 rotates. On the external surface of the engraving cylinder 1 there is a mould 2 of the micro-relief to be engraved, the mould generally being in the shape of a fine metal sheet, which comprises the micro-relief to be engraved on the outer face thereof, wrapped around a support cylinder 1. However, the micro-relief to be engraved could also be engraved directly onto the external surface of engraving cylinder 1. Guide rollers 15 cause a flexible laminate substrate 4, generally coming from a reel (not shown), to pass over a part of the external surface or mould 2 of cylinder 1 without there being any relative movement between them. Between the external surface of mould 2 of engraving cylinder 1 and said flexible laminate substrate 4 a liquid or pasty resin 3 is provided (which can be applied in various ways, flexography, intaglio printing, serigraphy or others) that can be hardened by actinic radiation R. In the illustrated example, resin 3 is deposited by a known unit 18 (a roller submerged in a container of resin associated with an applicator roller), directly onto substrate 4, which later passes over cylinder 1 with the face containing resin 3 being against mould 2. However, in other versions of the apparatus (not shown) it is equally possible to first deposit resin 3 on mould 2 of cylinder 1 before it comes into contact with the substrate, or deposit resin 3 only in the area where mould 2 and substrate 4 come into contact. Advantageously, at any event a pressing roller 16 or other device presses substrate 4 and resin 3 against mould 2. Opposite the part of the cylinder that is in close contact with resin 3 there is a curing lamp 5 that emits actinic radiation R on resin 3 through the substrate. The co-ordinated rotation speed of cylinder 1 and movement speed of substrate 4 are sufficient for resin 3 to remain in close contact with mould 2 on the external surface of engraving cylinder 1 for enough time while it receives actinic radiation R from lamp 5, whereby resin 3 is cured while in contact with mould 2 so that when said resin is separated from said mould it adheres to substrate 4 and maintains the features of the micro-relief of mould 2 intact. Lamp 5 must be at a distance from the external surface of mould 2 of engraving cylinder 1 that corresponds to the focal distance F of lamp 5.

The engraving unit described superficially with reference to Fig. 1 can use alternatively various, interchangeable engraving cylinders 1 with different diameters, providing that said distance between lamp 5 and the external surface of mould 2 of engraving cylinder 1 remains fixed, corresponding to focal distance F of lamp 5. In the state of the art devices, in order to facilitate cylinder withdrawal and positioning, lamp 5 has to be removed or moved away and in order to adequately maintain the focal distance F between the lamp and external surface of mould 2 of engraving cylinder 1, regardless of the diameter of the latter, the position of lamp 5 must be adjusted manually with respect to apparatus frame 17.

The device of this invention enables lamp 5 to be moved away from the engraving cylinder automatically in order to facilitate cylinder withdrawal and replacement operations, and then to be repositioned at focal distance F from the external surface of mould 2 of engraving cylinder 1, regardless of the diameter of the latter, thus avoiding having to manually adjust the position of lamp 5 with respect to apparatus frame 17 in order to maintain said focal distance F every time engraving cylinder 1 is replaced with another having a different diameter. This device is described below with reference to Figs. 2 to 8.

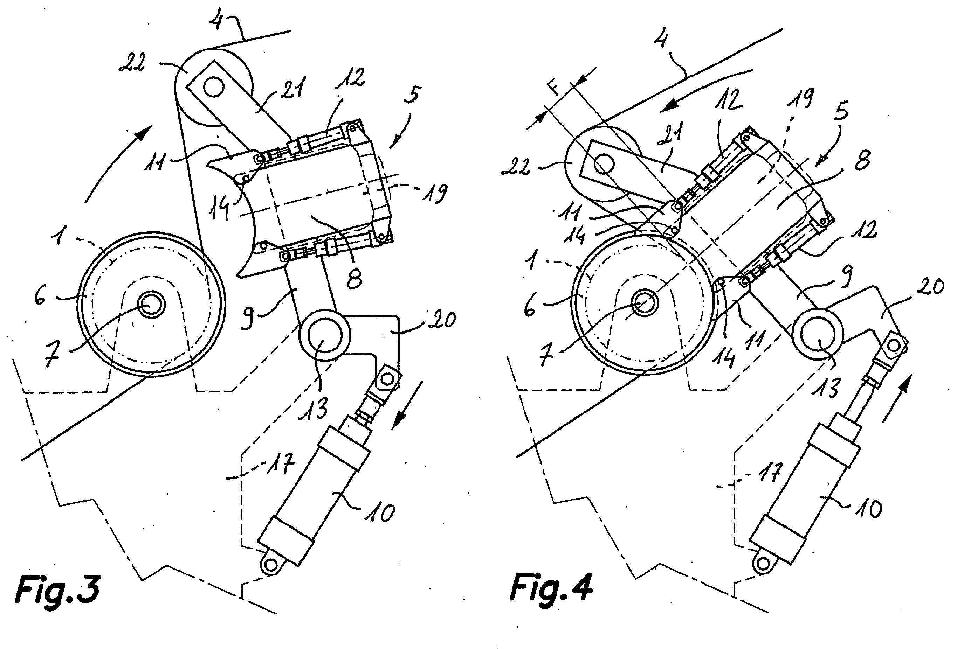

With reference to Fig. 2, as is conventional, each interchangeable engraving cylinder 1 has an shaft 7 the ends of which protrude from both sides of cylinder 1 and are shaped such that they can be attached and separated from supports (not shown) on the engraving unit of the apparatus. However, in the device of this invention, a pair of support discs 6 is mounted on said shaft 7, one on each side of cylinder 1 and separated therefrom, and resting in an operative manner on said discs 6 there are end stops 8, associated with a mobile support structure 9 of lamp 5, the workings of which are described with respect to Figs. 3 and 4. The length of said end stops 8 is fixed while the diameter of said support discs 6 depends on the diameter of the corresponding interchangeable engraving cylinder 1 and is selected so that the distance from lamp 5 to the external surface of mould 2 of engraving cylinder 1 is constant and corresponds to focal distance F of the lamp, regardless of the diameter of cylinder 1. The axial length of lamp 5 is sufficient to apply actinic radiation R along the whole axial length of that area of the external surface of mould 2 on engraving cylinder 1 that is in contact with resin 3, with one of said end stops 8 being fixed to support structure 9 at each side of the housing 19 of lamp 5. The axial distance between support discs 6 is fixed for all interchangeable engraving cylinders 1 and coincides with the axial distance between end stops 8, so that, when support structure 9 moves towards engraving cylinder 1, said end stops meet support discs 6 and abut against contact surfaces thereof, thus ensuring focal distance F.

Below reference is made to Figs. 3 and 4 that show mobile support structure 9 of lamp 5 mounted so that it can pivot with respect to shaft 13 that is supported on frame 17 (shown in dotted lines) of the apparatus. Housing 19 (shown in dotted lines) is fixed on mobile support structure 9, and contains lamp 5 and end stops 8. Frame 17 also supports engraving cylinder 1 (shown in double dotted lines), which is integral with shaft 7 on which support discs 6 are mounted. Mobile support structure 9 has, at its ends, a pair of arms 20 connected mechanically to respective fluids dynamic cylinders 10 attached to frame 17. When said fluid dynamic cylinders 10 are activated, mobile support structure 9 can be pivoted with respect to shaft 13, moving it between an inactive position, shown in Fig. 3, where lamp 5 is beyond interfering with the positioning or withdrawal path of the unit of cylinder 1, shaft 7 and support discs 6, and an active position, shown in Fig. 4, where lamp 5 is suitably positioned at focal distance F with respect to the external surface or mould 2 of cylinder 1, by virtue of the limited movement of support structure 9 imposed by contact between end stops 8 and support discs 6. Protruding from the end of mobile support structure 9 beyond shaft 13 there is another pair of arms 21, on which there is mounted a guide roller 22 over which laminate substrate 4 passes with resin 3 adhered thereto, so that said guide roller 22 contributes to positioning and tensing substrate 4 with resin 3 over the corresponding part of the external surface or mould 2 of cylinder 1 when mobile support structure 9 moves to the working position shown in Fig. 4.

On either side of each end stop 8 there is a pair of mobile pins 11, which are mounted so that they can pivot in relation to respective axes 14 and connected to respective fluid dynamic cylinders 12 associated with end stop 8 attached to mobile support structure 9. Said fluid dynamic cylinders 12 are driven to move said side pins 11 towards the corresponding guide disc 6 until they come into contact with it when end stop 8 meets support disc 6.

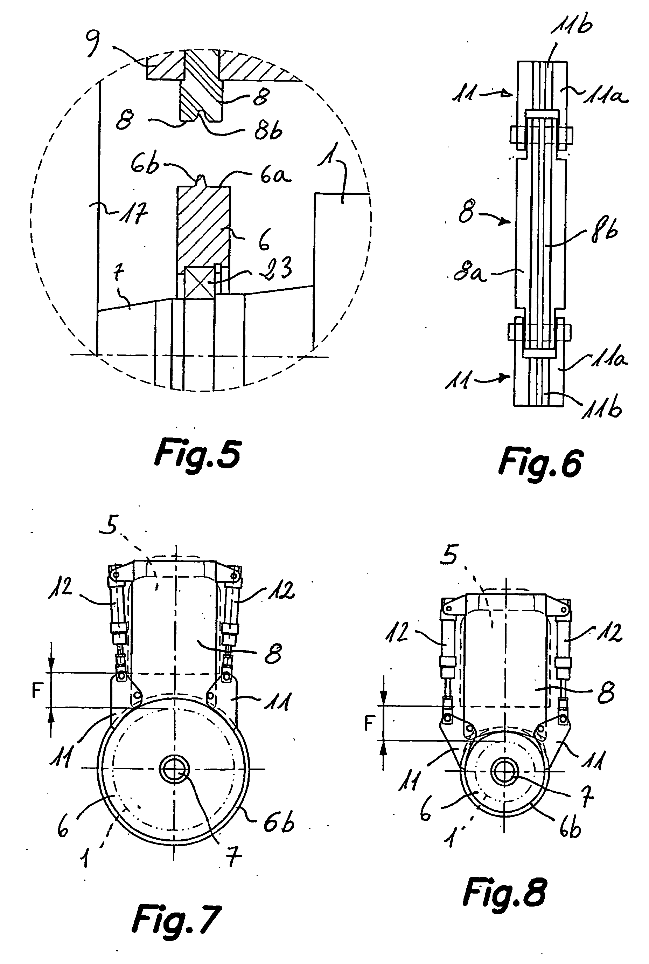

As can be appreciated further in Figs. 5 and 6, said support discs 6 comprise contact surfaces having a flat, relatively narrow and substantially cylindrical edge 6a, from which a circumferential flange 6b protrudes with conical sides, while end stops 8 have a contact surface 8a, that is relatively narrow and shaped substantially like a concave cylindrical sector, a groove 8b with conical sides being formed on contact surface 8a. The depth of groove 8b and the angle of its sides are equivalent to the height of flange 6b of support discs 6 and to the angle of the conical sides thereof, respectively. Each side pin 11 also has a concave contact surface 11 a provided with a groove 11 b having conical sides, the depth and angle being equivalent to the height and angle of flanges 6b of support discs 6, with said grooves 11 b on contact surfaces 11 a of side pins 11 being aligned with groove 8b on contact surface 8a of central end stop 8, as shown in Fig. 6. By way of this arrangement, the support of flat contact surfaces 8a of the end stops on flat contact surfaces 6a of support discs 6 (also see Fig. 2) guarantees focal distance F from lamp 5 to the external surface or mould 2 of engraving cylinder 1, while the engagement between conical flanges 6b of support discs 6 and conical grooves 8b and 11b of end stops 8 and respective pins 11 ensures that lamp 5 is positioned appropriately in the axial direction with respect to cylinder 1.

Figs. 2 and 5 also show the assembly of support discs 6. So, each support disc 6 is mounted on shaft 7 of engraving cylinder 1 by bearings, such as ball bearings 23, so that shaft 7 rotates with respect to support discs 6 while said discs remain stationary with respect to end stops 8 and corresponding side pins 11, thus avoiding any problems arising from friction between these parts.

As shown in Figs. 5 and 6, contact surface 8a of end stop 8 has a curvature radius equivalent to the maximum permissible radius of guide disc 6 (Fig. 7), which corresponds to the maximum permissible engraving cylinder. In this case the whole of contact surface 8a of end stop 8 rests on contact surface 6a of support disc 6 like contact surfaces 11a of side pins 11. When the diameter of engraving cylinder 1 is less than the maximum permissible (Fig. 8), the guide disc also has a proportionally smaller diameter and, therefore, contact surface 8a of end stop 8 only rests on contact surface 6a of support disc 6 in a central point and contact surfaces 11a of side pins 11 rest with their ends on contact surface 6a of support disc 6, whereby three separate points of contact are provided that ensure a stable support. However, at any event the accuracy of the distance between lamp 5 and the external surface or mould 2 of cylinder 1 corresponding to focal distance F is guaranteed by contact surfaces 8a of end stops 8 being supported on corresponding contact surfaces 6a of support discs 6.

Although the invention has been described in relation to a specific embodiment, this is merely an illustrative, non-limiting example of the object of this invention, the scope of which is defined in the attached claims.

## Claims

1. Device for positioning a curing radiation source on an engraving cylinder or engraving plate holder, that can be applied to an engraving apparatus or unit to continuously form a micro-relief that produces optical effects or another type of printing on a flexible laminate substrate, said engraving unit being able to use alternatively interchangeable engraving cylinders (1) with different diameters providing that a fixed distance is maintained between a source or lamp (5) and the external surface of engraving cylinder (1) corresponding to focal distance (F) of the lamp, **characterised in that** it comprises at least one support element (6) mounted on shaft (7) or body of each interchangeable engraving cylinder (1), with at least one end stop (8) associated with a mobile support structure (9) of lamp (5) resting in an operative manner on support element (6) of which there is at least one, the length of said end stop(s) (8) being fixed while the diameter of said support element (6) depends on the diameter of the corresponding interchangeable engraving cylinder (1), and is selected so that distance (F) between the lamp and the external surface of the cylinder is constant, regardless of the diameter of cylinder (1).

2. Device, according to claim 1, **characterised in that** said engraving apparatus or unit comprises an rotary engraving cylinder (1) on the external surface of which there is arranged a mould (2) of the micro-relief to be engraved, with a resin (3) being maintained temporarily between the external surface of said mould (2) of engraving cylinder (1) and a flexible laminate substrate (4) without there being any relative movement between these two and with resin (3) being cured while it is in contact with the external surface of mould (2) of engraving cylinder (1) by the radiation (R) from an actinic radiation lamp (5) through the substrate, and **in that** said support element (6) comprises at least one pair of support discs (6) mounted on shaft (7) of each interchangeable engraving cylinder (1), one on each side of the cylinder, next to the ends thereof and separated therefrom, with said end stops (8) resting in an operative manner on said discs (6).

3. Device, according to claim 1, **characterised in that** said mobile support structure (9) of lamp (5) is mounted so that it can pivot with respect to a shaft (13) and is connected mechanically to at least one fluid dynamic cylinder (10) which is driven to move mobile support structure (9) between an active position, in which lamp (5) is positioned at focal distance (F) with respect to the external surface of mould (2) of cylinder (1) and an inactive position, beyond interfering with the cylinder (1) positioning and withdrawal path.

4. Device, according to claim 1, **characterised in that** said support discs (6) comprise contact surfaces that have a flat, relatively narrow and substantially cylindrical edge (6a), from which there protrudes a circumferential flange (6b) with conical sides, while end stops (8) have a relatively narrow contact surface (8a), substantially in the shape of a concave cylindrical sector, there being formed on the contact surface a groove (8b) having conical sides, the depth and angle of which are equivalent to the height and conicity of flange (6b) on support discs (6), with the axial distance between support discs (6) being fixed for all cylinders (1) and coinciding with the axial distance between end stops (8), so that, when they move towards the cylinder, said end stops abut against said contact surfaces of the support discs.

5. Device, according to claim 3, **characterised in that** the curvature radius of contact surface (8a) shaped like a cylindrical section of end stops is equivalent to the radius of the maximum permissible guide disc (6), and each end stop (8) includes a pair of mobile side pins (11) mounted in a pivoting manner with respect to respective shafts (14) and connected to respective fluid dynamics cylinders (12) activated to move said side pins (11) towards the corresponding guide disc (6) until it meets said disc when end stop (8) comes into contact with support disc (6).

6. Device, according to claim 4, **characterised in that** each side pin (11) has a concave contact surface (11 a) provided with a groove (11 b) having conical sides, with the depth and angle being equivalent to the height and angle of flanges (6b) of support discs (6), said grooves (11 b) of contact surface (11 a) of side pins (11) being aligned with groove (8b) of contact surface (8a) of central end stop (8).

7. Device, according to claim 4, **characterised in that** support discs (6) are mounted by means of bearings, such as ball bearings (23), on shaft (7) of engraving cylinder (1) so that shaft (7) turns with respect to support discs (6) while said support discs remain stationary with respect to end stops (8) and corresponding side pins (11).

## Patentansprüche

1. Vorrichtung zur Positionierung einer Härtungsstrahlquelle an einem Gravierzylinder oder einem Gravierplattenhalter, der bei einer Graviermaschine oder -einrichtung zur kontinuierlichen Bildung eines Mikroreliefs zur Anwendung kommen kann, mit dem auf einem biegsamen Schichtpressstoffsubstrat optische Effekte oder eine andere Art von Druck erzielt werden können, wobei bei der Graviereinrichtung abwechselnd austauschbare Gravierzylinder (1) mit verschiedenen Durchmessern verwendet werden können, vorausgesetzt, dass zwischen einer Quelle oder Lampe (5) und der Außenfläche des Gravierzylinders (1) ein fester Abstand eingehalten wird, der der Brennweite (F) der Lampe entspricht, **dadurch gekennzeichnet, dass** sie zumindest ein Trägerelement (6) aufweist, das an einer Achse (7) oder dem Körper des jeweiligen Gravierzylinders (1) montiert ist, mit mindestens einem Endanschlag (8), der mit einer beweglichen Trägerstruktur (9) der Lampe (5) verbunden ist und betriebsfähig auf dem zumindest einen Trägerelement (6) aufliegt, wobei die Länge des Endanschlags bzw. der Endanschläge (8) fest ist, während der Durchmesser des Trägerelements (6) vom Durchmesser des entsprechenden auswechselbaren Gravierzylinders (1) abhängt und so ausgewählt ist, dass der Abstand (F) zwischen der Lampe und der Außenfläche des Zylinders ungeachtet des Zylinderdurchmessers (1) konstant ist.

2. Vorrichtung nach Anspruch 1, **dadurch gekennzeichnet, dass** die Graviermaschine oder -einrichtung einen Rotationsgravierzylinder (1) aufweist, an dessen Außenfläche eine Vorlage (2) des zu gravierenden Mikroreliefs angeordnet ist, wobei zwischen der Außenfläche der Vorlage (2) des Gravierzylinders (1) und einem biegsamen flächenförmigen Substrat (4) zeitweise ein Harz (3) gehalten wird, ohne dass zwischen beiden eine relative Bewegung stattfindet, wobei das Harz (3), während dieses mit der Außenfläche der Vorlage (2) des Gravierzylinders (1) in Berührung steht, durch Strahlung (R) aus einer aktinischen Strahlungslampe (5) durch das Substrat hindurch gehärtet wird, und dass das Trägerelement (6) zumindest ein Paar an der Achse (7) des jeweiligen austauschbaren Gravierzylinders (1) montierter Stützscheiben (6), und zwar eine auf jeder Seite des Zylinders, neben dessen Enden und davon getrennt aufweist, wobei die Endanschläge (8) betriebsfähig auf diesen Scheiben (6) aufliegen.

3. Vorrichtung nach Anspruch 1, **dadurch gekennzeichnet, dass** die bewegliche Trägerstruktur (9) der Lampe (5) so montiert ist, dass sie um eine Achse (13) schwenkbar ist und mechanisch mit mindestens einem flüssigkeitsdynamischen Zylinder (10) verbunden ist, der so angetrieben wird, dass er die bewegliche Trägerstruktur (9) zwischen einer aktiven Stellung, bei der die Lampe (5) von der Außenfläche der Vorlage (2) des Gravierzylinders (1) in einem der Brennweite (F) entsprechenden Abstand positioniert ist, und einer den Positionier- und Rückzugsweg des Zylinders (1) nicht störenden inaktiven Stellung verschiebt.

4. Vorrichtung nach Anspruch 1, **dadurch gekennzeichnet, dass** die Stützscheiben (6) Kontaktflächen mit einer flachen, relativ engen und im wesentlichen zylindrischen Kante (6a) aufweisen, von denen ein umlaufender Flansch (6b) mit konischen Seiten hervorsteht, während die Endanschläge (8) eine relativ enge Kontaktfläche (8a) aufweisen, die im wesentlichen die Form eines konkaven zylindrischen Abschnitts besitzt, wobei auf der Kontaktfläche eine Nut (8b) mit konischen Seiten ausgebildet ist, deren Tiefe und Winkel der Höhe und Kegelform des Flansches (6b) auf den Stützscheiben (6) entspricht, wobei der axiale Abstand zwischen den Stützscheiben (6) bei allen Zylindern (1) fest ist und gleich dem axialen Abstand zwischen den Endanschlägen (8) ist, so dass die Endanschläge bei ihrer Bewegung in Richtung auf die Zylinder gegen die Kontaktflächen der Stützscheiben stoßen.

5. Vorrichtung nach Anspruch 3, **dadurch gekennzeichnet, dass** der Krümmungsradius der wie eine zylindrische Fläche von Endanschlägen geformten Kontaktfläche (8a) gleich dem Radius der maximal zulässigen Führungsscheibe (6) ist und jeder Endanschlag (8) ein Paar beweglicher Seitenstifte (11) aufweist, die um die jeweiligen Achsen (14) schwenkbar angeordnet und mit den jeweiligen flüssigkeitsdynamischen Zylindern (12) verbunden sind, die zur Verschiebung der Seitenstifte (11) in Richtung der entsprechenden Führungsscheibe (6) angesteuert werden, bis sie beim Berühren der Stützscheibe (6) durch den Endanschlag (8) auf die Scheibe treffen.

6. Vorrichtung nach Anspruch 4, **dadurch gekennzeichnet, dass** die Seitenstifte (11) jeweils eine konkave Kontaktfläche (11a) mit einer Nut (11b) mit konischen Seiten aufweisen, wobei deren Tiefe und Winkel gleich der Höhe und dem Winkel der Flansche (6b) der Stützscheiben (6) sind, wobei die Nuten (11b) der Kontaktfläche (11a) der Seitenstifte (11) zur Nut (8b) der Kontaktfläche (8a) des mittleren Endanschlags (8) ausgerichtet sind.

7. Vorrichtung nach Anspruch 4, **dadurch gekennzeichnet, dass** die Stützscheiben (6) auf der Achse (7) des Gravierzylinders (1) mit Hilfe von Lagern wie z. B. Kugellagern (23) montiert sind, so dass sich die Achse (7) bezüglich der Stützscheiben (6) dreht, während die Stützscheiben (6) bezüglich der Endanschläge (8) und der entsprechenden Seitenstifte (11) feststehend sind.

## Revendications

1. Dispositif pour positionner une source de radiation de durcissage sur un cylindre graveur ou un support de plaque de gravure pouvant être appliquée sur un appareil ou unité de gravure pour former en continu une microrelief produisant des effets optiques ou un autre genre d'impression sur un substrat en couches flexible, cette unité de gravure pouvant utiliser alternativement des cylindres de gravure échangeables (1) à diamètres différents permettant qu'un certain écart soit maintenu entre une source ou lampe (5) et la surface externe du cylindre de gravure (1) correspondant à la distance focale (F) de la lampe, **caractérisé en ce qu'**il comporte au moins un élément de support (6) monté sur un axe (7) ou corps de chaque cylindre graveur échangeable (1), avec au moins une butée d'extrémité (8) associée à une structure de support mobile (9) de la lampe (5) reposant de façon opératoire sur l'élément de support (6) dont il y en a au moins un , la longueur de cette(ces) butée(s) d'extrémité (8) étant fixe tandis que le diamètre de cet élément de support (6) dépend du diamètre du cylindre graveur échangeable correspondant (1) et il est choisi de sorte que l'écart (F) entre la lampe et la surface externe du cylindre soit constant, indépendamment du diamètre du cylindre (1).

2. Dispositif, conformément à la revendication 1 **caractérisé en ce que** cet appareil ou unité de gravure comporte un cylindre graveur tournant (1) sur la surface externe duquel est agencé un moule (2) du microrelief à graver, une résine (3) étant maintenue provisoirement entre la surface externe de ce moule (2) du cylindre graveur (1) et un substrat en couches flexible(4) sans qu'il n'y ait de mouvement relatif entre ces deux et la résine (3) étant durcie pendant qu'elle est en contact avec la surface externe du moule (2) du cylindre graveur (1) par la radiation (R) provenant de la lampe de radiation actinique (5) à travers le substrat et **en ce que** cet élément de support (6) comporte au moins une paire de disques de support (6) montés sur un axe (7) de chaque cylindre graveur échangeable (1), un sur chaque côté du cylindre , près des extrémités de celui-ci et écartés de celui-ci, ces butées d'extrémité (8) reposant de façon opératoire sur ces disques (6).

3. Dispositif conformément à la revendication 1, **caractérisé en ce que** cette structure de support mobile (9) de la lampe (5) est montée de sorte qu'elle puisse pivoter par rapport à un axe (13) et est mécaniquement reliée, à au moins un cylindre hydrodynamique (10) qui est entraîné pour déplacer une structure de support mobile (9) entre une position active, dans laquelle la lampe (5) est positionnée à une distance focale (F) par rapport à la surface externe du moule (2) du cylindre (1) et une position inactive, loin d'interférer le positionnement du cylindre (1) et la piste d'entraînement.

4. Dispositif, conformément à la revendication 1, **caractérisé en ce que** ces disques de support (6) comportent des surfaces de contact ayant un bord plat, relativement étroit et sensiblement cylindrique (6a) d'où dépasse une bride circonférentielle (6b) à côtés coniques tandis que les butées d'extrémité (8) ont une surface de contact relativement étroite (8a), sensiblement en la forme d'un secteur cylindrique concave , une rainure (8b) étant formée sur la surface de contact à cotés coniques, dont la profondeur et l'angle sont équivalents à la hauteur et conicité de la bride (6b) sur les disques de support (6), la distance axiale entre les disques de support (6) étant fixe pour tous les cylindres (1) et coïncidant avec la distance axiale entre les butées d'extrémité (8) de sorte que lorsqu'elles avancent vers le cylindre, ces butées d'extrémité butent contre ces surfaces de contact des disques de support.

5. Dispositif, conformément à la revendication 3, **caractérisé en ce que** le rayon de courbure de surface de contact (8a) ayant une forme semblable à la section cylindrique des butées d'extrémité est équivalent au rayon du disque de guidage maximum permissible (6) et chacune des butées d'extrémité (8) comporte une paire de chevilles latérales mobiles (11) montées pivotantes par rapport aux axes respectifs (14) et reliés aux cylindres hydrodynamiques respectifs (12) activés pour déplacer ces chevilles latérales (11) vers le disque de guidage correspondant (6) jusqu'à ce qu'il rencontre ce disque lorsque la butée d'extrémité (8) entre en contact avec le disque de support (6).

6. Dispositif conformément à la revendication 4, **caractérisé en ce que** chaque cheville latérale (11) a une surface de contact concave (11a) pourvue d'une rainure (11 b) ayant des cotés coniques dont la profondeur et l'angle sont équivalents à la hauteur et à l'angle des brides (6b) des disques de support (6), ces rainures (11 b) de la surface de contact (11 a) des chevilles latérales (11) étant alignées avec la rainure (8b) de la surface de contact (8a) de la butée d'extrémité centrale (8).

7. Dispositif, conformément à la revendication 4, **caractérisée en ce que** les disques de support (6) sont montés au moyen de paliers tels que des roulements à bille (23) sur l'axe (7) du cylindre de gravure (1) de sorte que l'axe (7) tourne par rapport aux disques de support (6) tandis que ces disques de support restent fixes par rapport aux butées d'extrémité (8) et chevilles latérales correspondantes (11).
